# EUROPEAN PATENT APPLICATION

(11) **EP 4 467 273 A1**
(43) Date of publication of application: **27.11.2024**
(21) Application number: 23743142.4
(22) Date of filing: 10.01.2023
(51) Int. Cl.: B23H 5/06, B23K 20/00, C04B 37/00, G01N 24/00

(54) **SAMPLE TUBE FOR NUCLEAR MAGNETIC RESONANCE EQUIPMENT**

(30) Priority: 18.01.2022 JP 2022005447
(71) Applicant: KYOCERA CORPORATION, Kyoto-shi, Kyoto 612-8501 (JP)
(72) Inventor: OTA, Shoichi, Kyoto-shi, Kyoto 612-8501 (JP)
(74) Representative: Viering, Jentschura & Partner mbB Patent- und Rechtsanwälte
(86) International application number: PCT/JP2023/000316
(87) International publication number: WO 2023/140147

(57) **Abstract**

According to an embodiment of the present disclosure, a sample tube for a nuclear magnetic resonance apparatus includes a tubular portion having a cylindrical shape and containing a ceramic; and a bottom portion containing a ceramic, the bottom portion sealing one end portion of the tubular portion. A first opposing surface of the tubular portion facing the bottom portion and a second opposing surface of the bottom portion facing the tubular portion are diffusion-bonded.

## Description

### TECHNICAL FIELD

The present invention relates to a sample tube for a nuclear magnetic resonance apparatus.

### BACKGROUND OF INVENTION

Nuclear magnetic resonance (NMR) is a phenomenon in which atomic nuclei placed in an external magnetic field interact with electromagnetic waves of a specific frequency. The NMR phenomenon can be observed by NMR spectrometers and is used to study molecular physics, crystalline and amorphous materials. In particular, a nuclear spin phenomenon is used to generate spectra representative of various spins and spin interactions.

The nuclear spins encounter multiple interactions in a sample that broaden a spectral line width. However, such interactions are time-dependent. The averaging can be performed by rotating the cylindrical rotor in which the sample is accommodated in a state where the rotation axis of the rotor is inclined at a magic angle (54.74 degrees) with respect to a direction of an external magnetic field. By such averaging, the line width of the spectrum is narrowed, and identification of the spectrum is facilitated, or a resolution for analysis is improved. For example, Patent Document 1 describes a stator assembly to which the above-described rotor (sample tube for a nuclear magnetic resonance apparatus) is attached.

### CITATION LIST

### PATENT LITERATURE

Patent Document 1: JP 2011-95261 A

### SUMMARY

### SOLUTION TO PROBLEM

According to an embodiment of the present disclosure, a sample tube for a nuclear magnetic resonance apparatus includes a tubular portion having a cylindrical shape and containing a ceramic; and a bottom portion containing a ceramic and sealing one end portion of the tubular portion. A first opposing surface of the tubular portion facing the bottom portion and a second opposing surface of the bottom portion facing the tubular portion are diffusion-bonded to each other.

A bearing unit according to the present disclosure includes the above-described sample tube for a nuclear magnetic resonance apparatus; and a bearing made of a ceramic containing zirconium oxide or aluminum oxide as a main component, the bearing supporting both ends in an axial direction of the sample tube for a nuclear magnetic resonance apparatus. A nuclear magnetic resonance apparatus according to the present disclosure includes the bearing unit.

A manufacturing method of a sample tube for a nuclear magnetic resonance apparatus according to the present disclosure includes adhering water to the first opposing surface of the tubular portion and/or the second opposing surface of the bottom portion to adsorb the tubular portion and the bottom portion to each other, and then pressing the tubular portion and the bottom portion along the axial direction and performing heat treatment.

### BRIEF DESCRIPTION OF THE DRAWINGS

FIG. 1 is a perspective view illustrating a sample tube for a nuclear magnetic resonance apparatus according to an embodiment of the present disclosure.
FIG. 2 is an explanatory view illustrating a cross section taken along a line X-X illustrated in FIG. 1.
FIG. 3 is an explanatory view illustrating a state before diffusion-bonding of a tubular portion and a bottom portion.

### DESCRIPTION OF EMBODIMENTS

In a conventional rotor (a sample tube for a nuclear magnetic resonance apparatus), when improvement in resolution of an NMR apparatus is required, distortion of an external magnetic field needs to be reduced. For this purpose, suppressing an eccentricity of the rotor is needed as much as possible when the rotor is rotated. The integrally formed rotor has large warpage, and the warpage cannot be sufficiently reduced even by grinding. Therefore, when such a rotor is rotated, the eccentricity cannot be sufficiently suppressed, and the resolution of the NMR apparatus cannot be improved.

Therefore, a sample tube for a nuclear magnetic resonance apparatus that can reduce the eccentricity even when the rotation is applied, and can improve the resolution of the nuclear magnetic resonance apparatus has been demanded.

In a sample tube for a nuclear magnetic resonance apparatus of the present disclosure, a first opposing surface of a tubular portion facing a bottom portion and a second opposing surface of the bottom portion facing the tubular portion are diffusion-bonded. Therefore, the sample tube for a nuclear magnetic resonance apparatus of the present disclosure can reduce the eccentricity even when the rotation is applied, and can improve the resolution of the nuclear magnetic resonance apparatus.

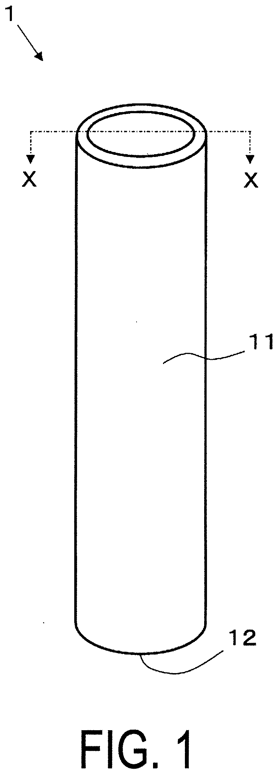

The sample tube for a nuclear magnetic resonance (NMR) apparatus according to an embodiment of the present disclosure will be described with reference to FIGs. 1 to 3. The sample tube for an NMR apparatus (hereinafter, the sample tube for an NMR apparatus may be simply referred to as a "sample tube") 1 according to an embodiment illustrated in FIG. 1 includes a tubular portion 11 and a bottom portion 12.

The tubular portion 11 has a cylindrical shape and contains a ceramic. The ceramic is not limited, and examples thereof include ceramics containing, as a main component, aluminum oxide, yttrium oxide, yttrium-aluminum composite oxide, magnesium oxide, silicon carbide, silicon nitride, zirconium oxide, titanium oxide, sialon, or the like. Among these ceramics, ceramics containing aluminum oxide as a main component are preferable.

In the present specification, a "main component" means a component contained at a ratio of 80 mass% or more when the total of the components constituting the ceramic is 100 mass%. The identification of each component contained in the ceramic may be performed with an X-ray diffractometer using a CuKα beam, and the content of each component may be determined, for example, with an inductively coupled plasma (ICP) emission spectrophotometer or a fluorescence X-ray spectrometer.

The use of ceramics containing aluminum oxide as a main component can reduce the cost of the sample tube 1. When the ceramic is a ceramic containing aluminum oxide as a main component, the ceramic may contain an oxide of magnesium, calcium, silicon, sodium, or the like.

A size of the tubular portion 11 is set in consideration of a size of a general sample tube. The tubular portion 11 has, for example, an outer diameter of 2 mm or more and 5 mm or less and an inner diameter of 1.5 mm or more and 4 mm or less, and has a width of 8 mm or more and 20 mm or less.

The bottom portion 12 is a member that seals one end portion of the tubular portion 11, and contains a ceramic. The ceramic is not limited, and examples thereof include ceramics containing, as a main component, aluminum oxide, yttrium oxide, yttrium-aluminum composite oxide, magnesium oxide, silicon carbide, silicon nitride, zirconium oxide, titanium oxide, sialon, or the like, as in the case of the tubular portion 11. Among these ceramics, ceramics containing aluminum oxide as a main component are preferable. When the ceramic is a ceramic containing aluminum oxide as a main component, the ceramic may contain an oxide of magnesium, calcium, silicon, sodium, or the like.

The tubular portion 11 and the bottom portion 12 may be made of a ceramic having the same main component or a ceramic having different main components. In consideration of productivity and the like, the tubular portion 11 and the bottom portion 12 are preferably made of a ceramic having the same main component.

A size of the bottom portion 12 is set in consideration of a size of a general sample tube. As described above, since the bottom portion 12 is a member that seals one end portion of the tubular portion 11, the outer diameter of the bottom portion 12 is designed to coincide with the outer diameter of the tubular portion 11. The bottom portion 12 is, for example, not less than 2 mm and not more than 10 mm thick. The bottom portion 12 has a disc shape or a columnar shape depending on the thickness.

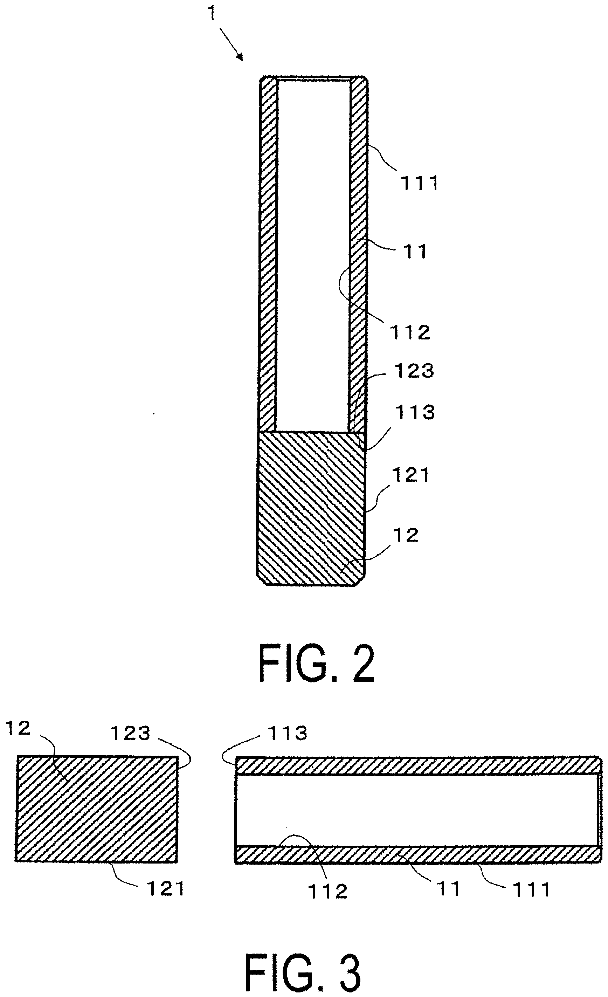

The tubular portion 11 and the bottom portion 12 are diffusion-bonded. Specifically, as illustrated in FIGs. 2 and 3, a first opposing surface 113 of the tubular portion 11 facing the bottom portion 12 and a second opposing surface 123 of the bottom portion 12 facing the tubular portion 11 are diffusion-bonded to each other.

The tubular portion 11 and the bottom portion 12 are not integrally formed. As illustrated in FIG. 3, large warpage of an outer peripheral surface 111 of the tubular portion 11 and shape tolerance of an inner peripheral surface 112, for example, variation in straightness, roundness, cylindricity, and the like, before diffusion-bonding can be suppressed. The coaxiality of the outer peripheral surface 111 with respect to the rotation axis of the tubular portion 11 can also be reduced. As a result, the eccentricity of the obtained sample tube 1 can be sufficiently reduced even when the sample tube 1 is rotated. The combination of the tubular portion 11 and the bottom portion 12 can be adjusted according to the required cost and the type of sample. As a result, the degree of freedom in design is also improved.

In the sample tube 1, the outer peripheral surface 111 of the tubular portion 11 and the outer peripheral surface 121 of the bottom portion 12 may have an average value of a cut level difference (Rδc), which is a difference between a cut level at a load length ratio of 25% in a roughness curve and a cut level at a load length ratio of 75% in the roughness curve, smaller than an average value of a Rδc in the inner peripheral surface 112 of the tubular portion 11. In such a case, the outer peripheral surface 111 of the tubular portion 11 and the outer peripheral surface 121 of the bottom portion 12 have unevenness less than unevenness of the inner peripheral surface 112 of the tubular portion 11.

When the unevenness of the outer peripheral surface 111 of the tubular portion 11 and the outer peripheral surface 121 of the bottom portion 12 is reduced, even if a gas for rotation is supplied toward the outer peripheral surface 111 of the tubular portion 11, a turbulent flow is less likely to occur. Therefore, the rotation of the sample tube 1 can be stabilized in a short time. As a result, the analysis efficiency of the sample can be improved. The inner peripheral surface 112 of the tubular portion 11 has appropriate unevenness, and the contact angle between the inner peripheral surface 112 and the liquid is reduced, thereby improving hydrophilicity (wettability). As a result, when the sample is cleaned after being analyzed, the residue of the cleaning liquid is less likely to adhere to the inner peripheral surface 112 of the tubular portion 11.

The cut level difference (Rδc) in the roughness curve is an indicator indicating the difference in the height direction between the cut levels C (Rmr1) and C (Rmr2) respectively corresponding to the load length ratios Rrm1 and Rrm2 in the roughness curve defined in JIS B0601:2001. A smaller value of the cut level difference (Rδc) in the roughness curve indicates a smoother surface with less unevenness.

The cut level difference (Rδc) can be measured by using a laser microscope (manufactured by KEYENCE Corporation, ultra-deep color 3D shape measuring microscope (VK-X1000 or successor models thereof)) in accordance with JIS B 0601: 2001. The measurement conditions include coaxial illumination, a measurement magnification of 480, no cut-off value λs, a cut-off value λc of 0.08 mm, correction of terminal effect, and a measurement range of 710 µm × 560 µm from the measurement target. For each measurement range, four lines to be measured are drawn at substantially equal intervals along the longitudinal direction of the measurement range to measure the line roughness.

The length of one line to be measured is, for example, 560 µm. Three measurement ranges are set from each of the outer peripheral surface 111 of the tubular portion 11, the outer peripheral surface 121 of the bottom portion 12, and the inner peripheral surface 112 of the tubular portion 11, the cut level difference (Rδc) is measured from a total of 12 lines drawn in each measurement range, and the average value thereof is calculated.

In the inner peripheral surface 112 of the tubular portion 11, the average value of the cut level difference (R6c), which is the difference between the cut level at a load length ratio of 25% in the roughness curve and the cut level at a load length ratio of 75% in the roughness curve, may be 0.07 µm or less (excluding 0 µm). With such a configuration, the inner peripheral surface 112 exhibits a mirror surface. As a result, in the case where the sample is a powder, even if the dirt adheres to the inner peripheral surface 112 of the tubular portion 11, the dirt can be easily found and removed.

In the sample tube 1, the inner peripheral surface 112 of the tubular portion 11 may have a larger average value of the root mean square slope (RΔq) in the roughness curve than the outer peripheral surface 111 of the tubular portion 11 and the outer peripheral surface 121 of the bottom portion 12. With such a configuration, the inner peripheral surface 112 of the tubular portion 11 has appropriate unevenness, and the contact angle between the inner peripheral surface 112 and the liquid is reduced, thereby improving hydrophilicity (wettability). As a result, when the sample is cleaned after being analyzed, the residue of the cleaning liquid is less likely to adhere to the inner peripheral surface 112 of the tubular portion 11.

The root mean square slope (RΔq) can be analyzed using a shape measure laser microscope (manufactured by Keyence Corporation, Ultra-Deep Color 3D Shape Measurement Microscope (VK - X1100 or its successor)) in accordance with JIS B 0601:2001. The measurement conditions are the same as those used in the measurement of the cut level difference (R6c).

In the inner peripheral surface 112 of the tubular portion 11, the average value of the root mean square slope (RΔq) in the roughness curve may be 0.07 or less (excluding 0). With such a configuration, in a case where the sample is a powder, adhesion of dirt to a recessed portion such as an open pore present in the inner peripheral surface 112 of the tubular portion 11 can be reduced.

In the sample tube 1, the outer peripheral surface 111 of the tubular portion 11 and the outer peripheral surface 121 of the bottom portion 12 may have an average value of a cut level difference (Rδc), which is a difference between a cut level at a load length ratio of 25% in a roughness curve and a cut level at a load length ratio of 75% in the roughness curve, larger than an average value of a Rδc in the inner peripheral surface 112 of the tubular portion 11. In such a case, the outer peripheral surface 111 of the tubular portion 11 and the outer peripheral surface 121 of the bottom portion 12 have unevenness more than unevenness of the inner peripheral surface 112 of the tubular portion 11.

With such a configuration, when a thin film such as a coil is formed on the outer peripheral surface 111 of the tubular portion 11, a sufficient anchor effect is exhibited. As a result, peeling of the thin film can be reduced. The inner peripheral surface 112 of the tubular portion 11 can be a glossy surface with little unevenness. As a result, in the case where the sample is a powder, even if the dirt adheres to the inner peripheral surface 112 of the tubular portion 11, the dirt can be easily found and removed.

When the outer peripheral surface 111 of the tubular portion 11 and the outer peripheral surface 121 of the bottom portion 12 have an average value of the cut level difference (Rδc) larger than the Rδc of the inner peripheral surface 112 of the tubular portion 11, in the outer peripheral surface 111 of the tubular portion 11, the average value of the cut level difference (Rδc), which is the difference between the cut level at a load length ratio of 25% in the roughness curve and the cut level at a load length ratio of 75% in the roughness curve, may be 0.4 µm or less (excluding 0 µm). With such a configuration, the unevenness present on the outer peripheral surface 111 of the tubular portion 11 is appropriately controlled. Therefore, even when the gas for rotation is supplied toward the outer peripheral surface 111 of the tubular portion 11, a turbulent flow is less likely to occur. As a result, the rotation of the sample tube 1 can be stabilized in a short time, and the analysis efficiency of the sample can be improved.

In the sample tube 1, the inner peripheral surface 112 of the tubular portion 11 may have a smaller average value of the root mean square slope (RΔq) in the roughness curve than the outer peripheral surface 111 of the tubular portion 11 and the outer peripheral surface 121 of the bottom portion 12. With such a configuration, the inner peripheral surface 112 of the tubular portion 11 can be a glossy surface with little unevenness. As a result, in the case where the sample is a powder, even if the dirt adheres to the inner peripheral surface 112 of the tubular portion 11, the dirt can be easily found and removed.

In the outer peripheral surface 111 of the tubular portion 11, the average value of the root mean square slope (RΔq) in the roughness curve may be 0.07 or less (excluding 0). With such a configuration, the unevenness present on the outer peripheral surface 111 of the tubular portion 11 is appropriately controlled. Therefore, even when the gas for rotation is supplied toward the outer peripheral surface 111 of the tubular portion 11, a turbulent flow is less likely to occur. As a result, the rotation of the sample tube 1 can be stabilized in a short time, and the analysis efficiency of the sample can be improved.

At least one of the second opposing surface 123, the outer peripheral surface 111 of the tubular portion 11, the inner peripheral surface 112 of the tubular portion 11, and the outer peripheral surface 121 of the bottom portion 12 may be a polished surface. The grain boundary phase in the polished surface may be subjected to etching treatment. The grain boundary phase of the polished surface is located in a state of being recessed from the crystalline particles when the etching treatment is performed. Therefore, by performing the etching treatment, the contact angle with respect to pure water is decreased, and the hydrophilicity is improved. As a result, when cleaning is performed using a water-soluble cleaning liquid, dirt can be efficiently removed.

The polishing method is not limited, and in a case where the second opposing surface 123 is a polished surface, for example, lapping polishing, magnetic fluid polishing, chemical mechanical polishing, or the like may be used. When the outer peripheral surface 111 of the tubular portion 11 and the outer peripheral surface 121 of the bottom portion 12 are polished surfaces, for example, after centerless grinding, mirror polishing using a lapping film, magnetic fluid polishing, polishing using a pin (hereinafter, polishing using a pin may be referred to as pin polishing), or the like are performed. In a case where the inner peripheral surface 112 of the tubular portion 11 is a polished surface, for example, pin polishing is performed after honing. Examples of the etching treatment include a thermal etching treatment and a chemical etching treatment.

A manufacturing method of the sample tube 1 according to the embodiment is not limited, and includes, for example, a step of adhering water to the first opposing surface 113 of the tubular portion 11 and/or the second opposing surface 123 of the bottom portion 12, adsorbing the tubular portion 11 and the bottom portion 12, and then pressing the tubular portion 11 and the bottom portion 12 along the axial direction and performing heat treatment. Specifically, the sample tube 1 is manufactured by the following procedure.

First, an embodiment of a manufacturing method of the tubular portion 11 will be described. When the main component of the ceramic forming the tubular portion 11 is aluminum oxide, powders of aluminum oxide (purity: 99.9 mass% or more), magnesium hydroxide, silicon oxide, calcium carbonate, and chromium oxide, and a solvent (ion-exchanged water) are put into a grinding mill.

Then grinding is performed until the average particle diameter (D₅₀) of the powder becomes equal to or less than 1.5 µm, and an organic binder and a dispersant that cause the powder of aluminum oxide to disperse are added and are mixed to obtain a slurry. Examples of the organic binder include acrylic emulsions, polyvinyl alcohol, polyethylene glycol, and polyethylene oxide.

Here, the content of the magnesium hydroxide powder is 1.5 mass% or more and 1.9 mass% or less, the content of the silicon oxide powder is 5.4 mass% or more and 5.8 mass% or less, the content of the calcium carbonate powder is 1.0 mass% or more and 1.4 mass% or less, the content of the chromium oxide powder is 3.7 mass% or more and 4.1 mass% or less, and the balance is the aluminum oxide powder and inevitable impurities, based on 100 mass% of the total of the powders. The total content of inevitable impurities is 0.1 mass% or less.

The slurry is spray-granulated to obtain granules, which are then filled in a mold and pressurized by using a uniaxial press molding apparatus or a cold isostatic press molding apparatus to obtain a cylindrical molded body. The forming pressure is, for example, 78 MPa or more and 128 MPa or less. The molded body is fired in an air atmosphere at 1500 °C or more and 1700 °C or less for 4 hours or more and 6 hours or less to obtain a cylindrical sintered body. The cylindrical sintered body has, for example, an outer diameter of 2 mm or more and 5 mm or less and an inner diameter of 1.5 mm or more and 4 mm or less, and has a width of 8 mm or more and 20 mm or less.

A case where the main component of the ceramic forming the tubular portion 11 is zirconium oxide will be described. Aluminum oxide powder in the range of 0.3 parts by mass to 5.0 parts by mass is added to and mixed with 100 parts by mass of zirconium oxide powder produced by a coprecipitation method with the addition amount of yttrium oxide as a stabilizer being 1 mole% or more and less than 3 mole%. Ion-exchanged water as a solvent is added to the mixture, and the resulting mixture is mixed and pulverized by a vibration mill, a ball mill, or the like.

The zirconium oxide powder preferably has an average particle diameter of 0.05 µm or more and less than 0.5 µm, and the aluminum oxide powder preferably has an average particle diameter of 0.5 µm or more and 2.0 µm or less. In this way, when the average particle diameter of the aluminum oxide powder is made to be larger than the average particle diameter of the zirconium oxide powder, the cracking action of the aluminum oxide powder having a large average particle diameter at the time of mixing and pulverizing helps prevent the aggregation of the zirconium oxide powder. A sintered body obtained by molding and firing the mixed and pulverized powder has good dispersibility of aluminum oxide and high density.

Examples of an applicable ball used for mixing and pulverization include a white ceramic ball including zirconium oxide, a white ceramic ball including aluminum oxide, or a white ceramic ball including zirconium oxide and aluminum oxide. Examples of the white ceramic balls include a ball including 91 mole% to 99 mole% of zirconium oxide (ZrO₂) having a purity of 99.5 mass% or more, and 1 mole% to 9 mole% of at least one type of stabilizer selected from yttrium oxide (Y₂O₃), hafnium oxide (HfO₂), cerium oxide (CeO₂), magnesium oxide (MgO), and calcium oxide (CaO), a ball obtained by further adding, into the ball of such a composition, 1 mass% to 40 mass% of aluminum oxide (Al₂O₃) having a purity of 99.5 mass% or more, or a ball consisted only of aluminum oxide having a purity of 99.5 mass% or more.

A predetermined amount of an organic binder is added to the mixed and pulverized powder, and the mixture is spray-granulated to obtain granules. Examples of the organic binder include acrylic emulsions, polyvinyl alcohol, polyethylene glycol, and polyethylene oxide. The granules obtained are filled into a molded body is obtained in the same way as described above. The molded body is fired in an air atmosphere at 1350 °C or more and 1550 °C or less for 4 hours or more and 6 hours or less to obtain a cylindrical sintered body. The cylindrical sintered body has the same size as described above.

Alternatively, a columnar sintered body may be obtained by firing a columnar molded body, and the obtained columnar sintered body may be subjected to grinding to form a cylindrical sintered body. The inner periphery of the obtained cylindrical sintered body is subjected to polishing or the like as necessary, whereby the tubular portion 11 is obtained.

An embodiment of a manufacturing method of the bottom portion 12 will be described. The bottom portion 12 is basically manufactured by a procedure the same as or similar to that for the tubular portion 11. Specifically, the same powder as the powder used to obtain the tubular portion 11 is used, and a slurry is subjected to spray granulation to obtain granules. Thereafter, a disc-shaped (or columnar depending on the thickness) molded body is obtained by a procedure the same as or similar to that for the tubular portion 11. When the main component of the molded body is aluminum oxide, a disc-shaped (columnar) sintered body is obtained by firing the molded body in an air atmosphere at a temperature of 1500 °C or more and 1700 °C or less for 4 hours or more and 6 hours or less. When the main component of the molded body is zirconium oxide, a disc-shaped (columnar) sintered body can be obtained by firing the molded body in an air atmosphere at 1350 °C or more and 1550 °C or less for 4 hours or more and 6 hours or less. The outer diameter of the disc-shaped (columnar) sintered body is designed to coincide with the outer diameter of the tubular portion 11. The disc-shaped (columnar) sintered body is, for example, not less than 2 mm and not more than 10 mm thick.

The sample tube 1 according to the embodiment is obtained by diffusion-bonding the tubular portion 11 and the bottom portion 12 obtained as described above. Specifically, the sample tube 1 is obtained by adhering water to the first opposing surface 113 of the tubular portion 11 and/or the second opposing surface 123 of the bottom portion 12, adsorbing the tubular portion 11 and the bottom portion 12 to each other, then pressing the tubular portion 11 and the bottom portion 12 along the axial direction, and subjecting the tubular portion 11 and the bottom portion 12 to heat treatment.

The pressing is performed by, for example, the weight of the tubular portion 11 or the bottom portion 12. The heat treatment is performed, for example, at a holding temperature of 1350 °C or more and 1550 °C or less for a holding time of 1 hour or more and 3 hours or less regardless of whether the main component of the ceramic forming the tubular portion 11 and the bottom portion 12 is aluminum oxide or zirconium oxide. Before performing the heat treatment, at least one of the first opposing surface 113 of the tubular portion 11 and the second opposing surface 123 of the bottom portion 12 may be a polished surface subjected to polishing treatment. The polished surface may be subjected to etching treatment such as a thermal etching treatment. By the etching treatment, the grain boundary phase on the polished surface recedes toward the inside by about several tens of nanometers from the crystalline particles, so that the angle of contact between the polished surface and the liquid is reduced to improve the hydrophilicity (wettability).

After the heat treatment, the outer periphery of the tubular portion 11 and/or the outer periphery of the bottom portion 12 may be subjected to grinding treatment or polishing treatment as necessary to form the outer peripheral surface 111 of the tubular portion 11 and the outer peripheral surface 121 of the bottom portion 12. The average value of the cut level difference (Rδc) and the average value of the root mean square slope (RΔq) is adjusted by changing the treatment conditions for the inner periphery of the tubular portion 11, the outer periphery of the tubular portion 11, and the outer periphery of the bottom portion 12.

Hereinafter, a specific method of adjusting these average values will be described. In order to make the average value of the cut level difference (Rδc) of the outer peripheral surface 111 of the tubular portion 11 and the outer peripheral surface 121 of the bottom portion 12 smaller than that of the inner peripheral surface 112 of the tubular portion 11, the outer peripheries of the tubular portion 11 and the bottom portion 12 are ground after diffusion-bonding. Thereafter, polishing treatment is performed using a slurry containing abrasive grains having a smaller average particle diameter D₅₀ than that of the abrasive grains used in the treatment of the inner periphery of the tubular portion 11. As the material of the abrasive grains, for example, diamond or the like may be mentioned, including the polishing treatment described later.

In order to set the average value of the cut level difference (Rδc) of the inner peripheral surface 112 of the tubular portion 11 to 0.07 µm or less (excluding 0 µm), grinding is performed before diffusion-bonding. Thereafter, polishing treatment is performed using a slurry containing abrasive grains having an average particle diameter D₅₀ of, for example, 4 µm or less.

In order to make the average value of the root mean square slope (RΔq) of the inner peripheral surface 112 of the tubular portion 11 larger than those of the outer peripheral surface 111 of the tubular portion 11 and the outer peripheral surface 121 of the bottom portion 12, the inner periphery of the tubular portion 11 is ground before diffusion-bonding. Thereafter, polishing treatment is performed using a slurry containing abrasive grains having a larger average particle diameter D₅₀ than the abrasive grains used in the treatment of the outer peripheries of the tubular portion 11 and the bottom portion 12.

In order to set the average value of the root mean square slope (RΔq) of the inner peripheral surface 112 of the tubular portion 11 to 0.07 or less (excluding 0), grinding is performed before diffusion-bonding. Thereafter, a slurry containing abrasive grains having an average particle diameter D₅₀ of, for example, 2 µm or less is used for a polishing time of 70 seconds or more. In order to make the average value of the cut level difference (Rδc) larger on the outer peripheral surface 111 of the tubular portion 11 and the outer peripheral surface 121 of the bottom portion 12 than the Rδc on the inner peripheral surface 112 of the tubular portion 11, the outer peripheries of the tubular portion 11 and the bottom portion 12 are polished using a slurry containing abrasive grains having a larger average particle diameter D₅₀ than that of the abrasive grains used in the treatment of the inner periphery of the tubular portion 11.

In order to set the average value of the cut level difference (Rδc) of the outer peripheral surface 112 of the tubular portion 11 to 0.4 µm or less (excluding 0 µm), grinding is performed after diffusion-bonding. Thereafter, polishing treatment is performed using a slurry containing abrasive grains having an average particle diameter D₅₀ of, for example, 8 µm or more and 10 µm or less.

In order to make the average value of the root mean square slope (RΔq) of the inner peripheral surface 112 of the tubular portion 11 smaller than those of the outer peripheral surface 111 of the tubular portion 11 and the outer peripheral surface 121 of the bottom portion 12, the inner periphery of the tubular portion 11 is ground before the diffusion-bonding. Thereafter, polishing treatment is performed using a slurry containing abrasive grains having a smaller average particle diameter D₅₀ than the abrasive grains used in the treatment of the outer peripheries of the tubular portion 11 and the bottom portion 12.

In order to set the average value of the root mean square slope (RΔq) of the outer peripheral surface 111 of the tubular portion 11 to 0.07 or less (excluding 0), a slurry containing abrasive grains having an average particle diameter D₅₀ of, for example, 1 µm or less is used, and the polishing time is set to 50 seconds or more.

After the treatment, the polished surface may be subjected to etching treatment such as thermal etching treatment. By the etching treatment, the grain boundary phase on the polished surface recedes toward the inside by about several tens of nanometers from the crystalline particles, so that the angle of contact between the polished surface 112 and the liquid is reduced to improve the hydrophilicity (wettability).

In the sample tube 1 obtained in this manner, large warpage of the outer peripheral surface 111 of the tubular portion 11 and variation in shape tolerance of the inner peripheral surface 112 before diffusion-bonding can be suppressed. As a result, the eccentricity of the obtained sample tube 1 can be sufficiently reduced even when the sample tube 1 is rotated. The combination of the tubular portion 11 and the bottom portion 12 can be adjusted according to the required cost and the type of sample. As a result, the degree of freedom in design is also improved.

A sample tube according to the present disclosure is a member included in a nuclear magnetic resonance (NMR) apparatus. Specifically, a bearing unit provided in an NMR apparatus includes the sample tube.

The bearing unit includes the sample tube according to the present disclosure and a bearing that supports both ends of the sample tube in the axial direction. The bearing is made of, for example, ceramics containing zirconium oxide or aluminum oxide as a main component.

In the NMR apparatus including the sample tube according to the present disclosure, the eccentricity can be reduced even when the sample tube is rotated, and the resolution of the nuclear magnetic resonance apparatus can be improved.

### EXAMPLE

### Example 1

2.7 parts by mass of an aluminum oxide powder was added to and mixed with 100 parts by mass of a zirconium oxide powder produced by a coprecipitation method using 2 mole% of yttrium oxide as a stabilizer, ion-exchanged water as a solvent was further added to a ball mill, and the mixture was mixed and pulverized with balls made of zirconium oxide having a purity of 99.5 mass% or more. Here, the average particle diameter of the zirconium oxide powder was 0.28 µm, and the average particle diameter of the aluminum oxide powder was 1.3 µm. After the mixing and pulverization, a predetermined amount of paraffin wax was further added as a binder, and the mixture was spray-dried with a spray dryer to obtain granules.

The obtained granules were filled in a molding die and pressed using a uniaxial press molding apparatus to obtain a cylindrical molded body and a disc-shaped molded body. The compacting pressure was 98 Ma. These molded bodies were fired in an air atmosphere at a holding temperature of 1450 °C for a holding time of 5 hours to obtain a tubular portion as a cylindrical sintered body and a bottom portion as a disc-shaped sintered body.

Next, the inner periphery of the tubular portion was honed as follows. The tubular portion was held in a state of being rotated in the 2000 rpm with the shaft of the tubular portion as a rotation axis. The rotation axis of the grinding tool was inclined by 1.8 ° with respect to the rotation axis of the outer peripheral surface of the tubular portion, and the grinding tool was rotated in the 120000 rpm in a direction opposite to the rotation direction of the tubular portion. The grinding tool was reciprocated while being brought into contact with the inner peripheral surface of the tubular portion along the axial direction of the tubular portion, and the inner peripheral surface was ground by honing. As a grinding tool, a tool having an outer diameter of 1.8 mm and diamond abrasive grains having an average particle diameter of 20 µm fixed to the tip portion was used.

After the honing, the inner periphery of a part of the tubular portion was pin-polished using a pin coated with a slurry containing diamond abrasive grains having an average particle diameter shown in Table 1. Some of the tubular portions are Sample Nos. 3 to 5 shown in Table 1, and the tubular portions of Sample Nos. 1 and 2 are not subjected to pin polishing. One end surface of the tubular portion and a main surface of the bottom portion facing the end surface were lapped and polished to form a first opposing surface and a second opposing surface, respectively. The tubular portion was 11 mm long, had an inner diameter of 2 mm, and an outer diameter of 3.2 mm. The bottom portion was 5 mm thick, and the outer diameter was 3.2 mm.

The tubular portion and the bottom portion are diffusion-bonded to each other in a state where the first opposing surface and the second opposing surface face each other. The holding temperature for diffusion-bonding was 1450 °C, and the holding time was 2 hours. The outer periphery of the tubular portion and the outer periphery of the bottom portion were centerless ground. Next, using a pin coated with a slurry containing diamond abrasive grains having an average particle diameter shown in Table 1, the outer periphery, the inner periphery, and the outer periphery of the bottom portion of the tubular portion were pin-polished to form the outer peripheral surface of the tubular portion, the inner peripheral surface of the tubular portion, and the outer peripheral surface of the bottom portion, respectively. The sample tubes obtained by this pin polishing are Sample Nos. 3 to 5. The polishing time is as shown in Table 1.

As a comparative example, a bottomed cylindrical sintered body was produced by filling a mold with the granules, integrally molding and firing the granules. Next, the outer periphery of the sintered body was subjected to centerless grinding, and a sample tube obtained by pin polishing using a pin coated with a slurry containing diamond abrasive grains having an average particle diameter shown in Table 1 was used as Sample No. 1. The grinding amount (grinding depth) of the outer periphery by the centerless grinding was set to be the same in Sample Nos. 1 to 5.

The cut level difference (Rδc), which is the difference between the cut level at a load length ratio of 25% in the roughness curve and the cut level at a load length ratio of 75% in the roughness curve, was measured for each of the outer peripheral surface of the tubular portion, the outer peripheral surface of the bottom portion, and the inner peripheral surface of the tubular portion, and the average value was determined. For the inner peripheral surface of the tubular portion, after the coaxiality of the outer peripheral surface described later was measured, each sample was cut along the rotation axis of the tubular portion, and the cut level difference (Rδc) was measured.

The method for measuring the cut level difference (Rδc) is the method described above. The coaxiality of the outer peripheral surface with respect to the rotation axis of the tubular portion was measured using a coaxiality measuring device in accordance with JIS B 0621: 1984. Here, the rotation axis of the tubular portion is a datum axis straight line defined by JIS B 0621:1984. The surface state of the inner peripheral surface was visually observed. Table 1 shows the average value of the cut level difference (Rδc), the measured value of the coaxiality, and the observation result of the surface state.

**[Table 1]**

| NO. | Average particle diameter (D₅₀) (µm) | | Polishing time of outer peripheral surfaces of tubular portion and bottom portion (sec) | Polishing time of inner peripheral surface of tubular portion (sec) | Average value of cut level difference (Rδc) (µm) | | | Coaxiality of outer peripheral surfaces of tubular portion and bottom portion (µm) | Surface state of inner peripheral surface of tubular portion |
|---|---|---|---|---|---|---|---|---|---|
| | Outer peripheral surfaces of the tubular portion and the bottom portion | Inner peripheral surface of tubular portion | | | Outer peripheral surface of tubular portion | Outer peripheral surface of bottom portion | Inner peripheral surface of tubular portion | | |
| 1 | 1 | - | 40 | - | 0.6 | 0.6 | 0.7 | 20 | Non-mirror surface |
| 2 | 1 | - | 40 | - | 0.05 | 0.05 | 0.6 | 5 | Non-mirror surface |
| 3 | 1 | 10 | 40 | 40 | 0.05 | 0.05 | 0.4 | 3 | Non-mirror surface |
| 4 | 1 | 4 | 40 | 40 | 0.05 | 0.05 | 0.07 | 3 | Mirror surface |
| 5 | 1 | 3 | 40 | 40 | 0.05 | 0.05 | 0.065 | 3 | Mirror surface |
| 6 | 1 | 2 | 40 | 40 | 0.05 | 0.05 | 0.06 | 3 | Mirror surface |

| | | | | | | | | | |
|---|---|---|---|---|---|---|---|---|---|
| Sample No. 1 is outside the scope of the present disclosure. | | | | | | | | | |

In sample No. 2 to No. 6, the first opposing surface of the tubular portion facing the bottom portion and the second opposing surface of the bottom portion facing the tubular portion are diffusion-bondend. Therefore, as shown in Table 1, the coaxiality between the outer

peripheral surface of the tubular portion and the outer peripheral surface of the bottom portion is small. Therefore, it can be said that Sample Nos. 2 to 6 can sufficiently reduce the eccentricity even when rotated.

In the Sample No. 2 to No. 6, the outer peripheral surface of the tubular portion and the outer peripheral surface of the bottom portion have a smaller average value of the cut level difference (Rδc) than the inner peripheral surface of the tubular portion. Therefore, in Sample Nos. 2 to 6, it can be said that the coaxiality of the outer peripheral surface with respect to the rotation axis of the tubular portion is small. Therefore, even when the gas for rotation is supplied toward the outer peripheral surfaces of the tubular portion and the bottom portion, a turbulent flow is less likely to occur, and it can be said that the analysis efficiency of the sample can be improved.

In Sample Nos. 4 to 6, the average value of the cut level difference (Rδc) of the inner peripheral surface of the tubular portion is 0.07 µm or less, and the inner peripheral surface has a mirror surface. Therefore, when the sample is a powder, it can be said that even if the dirt adheres to the inner peripheral surface, the dirt can be easily found and easily removed.

### Example 2

The inner periphery of the tubular portion obtained by the same manufacturing method as that illustrated in Example 1 was honed. After the honing, the inner periphery of the tubular portion was pin-polished using a pin coated with a slurry containing diamond abrasive grains having an average particle diameter shown in Table 2. One end surface of the tubular portion and a main surface of the bottom portion facing the end surface were lapped and polished to form a first opposing surface and a second opposing surface, respectively. The bottom portion was obtained in the same manner as in Example 1.

The tubular portion and the bottom portion were diffusion-bonded by the same manufacturing method as the manufacturing method illustrated in Example 1. The outer periphery of the tubular portion and the outer periphery of the bottom portion were centerless ground. Thereafter, the outer periphery of the tubular portion, the inner periphery of the tubular portion, and the outer periphery of the bottom portion were pin-polished using a pin coated with a slurry containing diamond abrasive grains having an average particle diameter shown in Table 2 to obtain sample tubes of Sample Nos. 7 to 11 having the outer peripheral surface of the tubular portion, the inner peripheral surface of the tubular portion, and the outer peripheral surface of the bottom portion, respectively. The polishing time is as shown in Table 2.

The root mean square slope (RΔq) and coaxiality were determined in the same manner as in Example 1. The surface state of the inner peripheral surface was visually observed, and the contact angle with respect to pure water was measured. The contact angle of pure water with respect to the inner peripheral surface was obtained by a sessile drop method described in JIS R 3257:1999. Table 2 shows the average value of the root mean square slope (RΔq), the measured value of the coaxiality, the observation result of the surface state, and the contact angle of pure water with respect to the inner peripheral surface.

**[Table 2]**

| NO. | Average particle diameter (D₅₀) (µm) | | Polishing time of outer peripheral surfaces of tubular portion and bottom portion (sec) | Polishing time of inner peripheral surface of tubular portion (sec) | Average value of root mean square slope (RΔq) | | | Coaxiality of outer peripheral surfaces of tubular portion and bottom portion (µm) | Contact angle of inner peripheral surface of tubular portion (°) | Surface state of inner peripheral surface of tubular portion |
|---|---|---|---|---|---|---|---|---|---|---|
| | Outer peripheral surfaces of the tubular portion and the bottom portion | Inner peripheral surface of tubular portion | | | Outer peripheral surface of tubular portion | Outer peripheral surface of bottom portion | Inner peripheral surface of tubular portion | | | |
| 7 | 4 | 2 | 40 | 40 | 0.3 | 0.3 | 0.25 | 5 | 26 | Non-mirror surface |
| 8 | 0.5 | 2 | 40 | 40 | 0.04 | 0.04 | 0.25 | 3 | 26 | Non-mirror surface |
| 9 | 0.5 | 2 | 40 | 70 | 0.04 | 0.04 | 0.07 | 3 | 30 | Mirror surface |
| 10 | 0.5 | 2 | 40 | 80 | 0.04 | 0.04 | 0.06 | 3 | 32 | Mirror surface |
| 11 | 0.5 | 2 | 40 | 90 | 0.04 | 0.04 | 0.05 | 3 | 34 | Mirror surface |

As shown in Table 2, the inner peripheral surface of the tubular portion of each of Sample Nos. 8 to 11 has a larger average value of the root mean square slope (RΔq) than the outer peripheral surface of the tubular portion and the outer peripheral surface of the bottom portion. Therefore, in Sample Nos. 8 to 11, the coaxiality between the outer peripheral surface of the tubular portion and the outer peripheral surface of the bottom portion is small, the contact angle of pure water with respect to the inner peripheral surface is small, and the hydrophilicity (wettability) is improved. As a result, it can be said that when the sample is cleaned after being analyzed, the residue of the cleaning liquid is less likely to adhere to the inner peripheral surface.

In Sample Nos. 9 to 11, the average value of the root mean square slope (RΔq) of the inner peripheral surface of the tubular portion is 0.07 or less. As a result, the inner peripheral surface exhibits a mirror surface, and when the sample is a powder, it can be said that adhesion of dirt to a recessed portion such as an open pore present on the inner peripheral surface can be reduced.

### Example 3

The inner periphery of the tubular portion obtained by the same manufacturing method as that illustrated in Example 1 was honed. After the honing, the inner periphery of the tubular portion was pin-polished using a pin coated with a slurry containing diamond abrasive grains having an average particle diameter shown in Table 3. One end surface of the tubular portion and a main surface of the bottom portion facing the end surface were lapped and polished to form a first opposing surface and a second opposing surface, respectively. The bottom portion was obtained in the same manner as in Example 1.

The tubular portion and the bottom portion were diffusion-bonded by the same manufacturing method as the manufacturing method illustrated in Example 1. The outer periphery of the tubular portion and the outer periphery of the bottom portion were centerless ground. Thereafter, the outer periphery of the tubular portion, the inner periphery of the tubular portion, and the outer periphery of the bottom portion were pin-polished using a pin coated with a slurry containing diamond abrasive grains having an average particle diameter shown in Table 3 to obtain sample tubes of Sample Nos. 12 to 15 having the outer peripheral surface of the tubular portion, the inner peripheral surface of the tubular portion, and the outer peripheral surface of the bottom portion, respectively. The polishing time is as shown in Table 3.

The cut level difference (Rδc) and the coaxiality were determined in the same manner as in Example 1. The surface states of the outer peripheral surface of the tubular portion, the inner peripheral surface of the tubular portion, and the outer peripheral surface of the bottom portion were visually observed. Table 3 shows the average value of the cut level difference (R6c), the measured value of the coaxiality, and the observation result of the surface state.

**[Table 3]**

| NO. | Average particle diameter (D₅₀) (µm) | | Polishing time of outer peripheral surfaces of tubular portion and bottom portion (sec) | Polishing time of inner peripheral surface of tubular portion (sec) | Average value of cut level difference (Rδc) (µm) | | | Coaxiality of outer peripheral surfaces of tubular portion and bottom portion (µm) | Surface state of outer peripheral surfaces of tubular portion and bottom portion | Surface state of inner peripheral surface of tubular portion |
|---|---|---|---|---|---|---|---|---|---|---|
| | Outer peripheral surfaces of the tubular portion and the bottom portion | Inner peripheral surface of tubular portion | | | Outer peripheral surface of tubular portion | Outer peripheral surface of bottom portion | Inner peripheral surface of tubular portion | | | |
| 12 | 1 | 4 | 40 | 40 | 0.05 | 0.05 | 0.07 | 3 | Mirror surface | Mirror surface |
| 13 | 10 | 4 | 20 | 40 | 0.5 | 0.5 | 0.07 | 6 | Non-mirror surface | Mirror surface |
| 14 | 10 | 4 | 40 | 40 | 0.4 | 0.4 | 0.07 | 5 | Non-mirror surface | Mirror surface |
| 15 | 8 | 3 | 40 | 40 | 0.3 | 0.2 | 0.065 | 5 | Non-mirror surface | Mirror surface |

As shown in Table 3, the outer peripheral surface of the tubular portion and the outer peripheral surface of the bottom portion of each of Sample Nos. 13 to 15 have a larger average value of the cut level difference (Rδc) than the inner peripheral surface of the tubular portion, and each of these outer peripheral surfaces is a non-mirror surface. Therefore, the outer peripheral surfaces of the tubular portion and the bottom portion of Sample Nos. 13 to 15 exhibit a sufficient anchor effect when a thin film such as a coil is formed. As a result, it can be said that the thin film is not easily peeled off. Since the inner peripheral surface of the tubular portion is a mirror surface, the inner peripheral surface is a glossy surface with little unevenness. In the case where the sample is a powder, it can be said that even if the dirt adheres to the inner peripheral surface of the tubular portion, the dirt can be easily found and removed.

In Sample Nos. 14 and 15, since the average value of the cut level difference (Rδc) of the outer peripheral surface of the tubular portion is 0.4 µm or less, the unevenness present on the outer peripheral surface is appropriately controlled. Therefore, even when the gas for rotation is supplied toward the outer peripheral surface, a turbulent flow is less likely to occur. As a result, it can be said that the rotation of the sample tube 1 can be stabilized in a short time and the analysis efficiency of the sample can be improved.

### Example 4

The inner periphery of the tubular portion obtained by the same manufacturing method as that illustrated in Example 1 was honed. After the honing, the outer periphery of the tubular portion, the inner periphery of the tubular portion, and the outer periphery of the bottom portion were pin-polished using a pin coated with a slurry containing diamond abrasive grains having an average particle diameter shown in Table 4. One end surface of the tubular portion and a main surface of the bottom portion facing the end surface were lapped and polished to form a first opposing surface and a second opposing surface, respectively. The bottom portion was obtained in the same manner as in Example 1.

The tubular portion and the bottom portion were diffusion-bonded by the same manufacturing method as the manufacturing method illustrated in Example 1. The outer periphery of the tubular portion and the outer periphery of the bottom portion were subjected to centerless grinding, and then the outer periphery of the tubular portion, the inner periphery of the tubular portion, and the outer periphery of the bottom portion were pin-polished using a pin coated with a slurry containing diamond abrasive grains having an average particle diameter shown in Table 4. Sample Nos. 16 to 20 were obtained as sample tubes having the outer peripheral surface of the tubular portion, the inner peripheral surface of the tubular portion, and the outer peripheral surface of the bottom portion, respectively. The polishing time is as shown in Table 4. The root mean square slope (RΔq) and coaxiality were determined in the same manner as in Example 1. The surface state of the inner peripheral surface was visually observed. Table 4 shows the average value of the root mean square slope (RΔq), the measured value of the coaxiality, and the observation result of the surface state.

**[Table 4]**

| NO. | Average particle diameter (D₅₀) (µm) | | Polishing time of outer peripheral surfaces of tubular portion and bottom portion (sec) | Polishing time of inner peripheral surface of tubular portion (sec) | Average value of root mean square slope (RΔq) | | | Coaxiality of outer peripheral surfaces of tubular portion and bottom portion (µm) | Surface state of outer peripheral surfaces of tubular portion and bottom portion | Surface state of inner peripheral surface of tubular portion |
|---|---|---|---|---|---|---|---|---|---|---|
| | Outer peripheral surfaces of the tubular portion and the bottom portion | Inner peripheral surface of tubular portion | | | Outer peripheral surface of tubular portion | Outer peripheral surface of bottom portion | Inner peripheral surface of tubular portion | | | |
| 16 | 4 | 4 | 40 | 40 | 0.3 | 0.3 | 0.3 | 5 | Non-mirror surface | Non-mirror surface |
| 17 | 1 | 1 | 40 | 80 | 0.09 | 0.09 | 0.04 | 5 | Non-mirror surface | Mirror surface |
| 18 | 1 | 1 | 50 | 80 | 0.07 | 0.07 | 0.04 | 4.8 | Mirror surface | Mirror surface |
| 19 | 1 | 1 | 60 | 80 | 0.06 | 0.06 | 0.04 | 4.2 | Mirror surface | Mirror surface |
| 20 | 1 | 1 | 70 | 80 | 0.05 | 0.05 | 0.04 | 4.2 | Mirror surface | Mirror surface |

As shown in Table 4, the inner peripheral surface of the tubular portion of each of Sample Nos. 17 to 20 has a smaller average value of the root mean square slope (RΔq) than the outer peripheral surface of the tubular portion and the outer peripheral surface of the bottom portion. Therefore, the inner peripheral surface of the tubular portion is a glossy surface with little unevenness. As a result, it can be said that when the sample is a powder, even if the dirt adheres to the inner peripheral surface of the tubular portion, the dirt can be easily found and easily removed.

Since the average value of the root mean square slope (RΔq) of the outer peripheral surface of the tubular portion of each of Sample Nos. 18 to 20 is 0.07 or less, the unevenness present on the outer peripheral surface of the tubular portion is appropriately controlled. Therefore, even when the gas for rotation is supplied toward the outer peripheral surface of the tubular portion, a turbulent flow is less likely to occur. As a result, the rotation of the sample tube can be stabilized in a short time, and the analysis efficiency of the sample can be improved.

### REFERENCE SIGNS

1 Sample tube for nuclear magnetic resonance (NMR) apparatus (sample tube)
11 Tubular portion
111 Outer peripheral surface of tubular portion
112 Inner peripheral surface of tubular portion
113 First opposing surface
12 Bottom portion
121 Outer peripheral surface of bottom portion
123 Second opposing surface

## Claims

1. A sample tube for a nuclear magnetic resonance apparatus, the sample tube comprising:
a tubular portion having a cylindrical shape and comprising a ceramic; and
a bottom portion comprising a ceramic and sealing one end portion of the tubular portion,
wherein a first opposing surface of the tubular portion facing the bottom portion and a second opposing surface of the bottom portion facing the tubular portion are diffusion-bonded to each other.

2. The sample tube for a nuclear magnetic resonance apparatus, according to claim 1, wherein an average value of a cut level difference (Rδc) in each of outer peripheral surfaces of the tubular portion and the bottom portion is smaller than an average value of a Rδc in an inner peripheral surface of the tubular portion, the Rδc being a difference between a cut level at a load length ratio of 25% in a roughness curve and a cut level at a load length ratio of 75% in the roughness curve.

3. The sample tube for a nuclear magnetic resonance apparatus, according to claim 2, wherein the average value of the cut level difference (Rδc) in the inner peripheral surface of the tubular portion is 0.07 µm or less (excluding 0 µm), the Rδc being the difference between the cut level at a load length ratio of 25% in the roughness curve and the cut level at a load length ratio of 75% in the roughness curve.

4. The sample tube for a nuclear magnetic resonance apparatus, according to any one of claims 1 to 3, wherein the inner peripheral surface of the tubular portion has a larger average value of a root mean square slope (RΔq) in a roughness curve than each of outer peripheral surfaces of the tubular portion and the bottom portion.

5. The sample tube for a nuclear magnetic resonance apparatus, according to claim 4, wherein the average value of the root mean square slope (RΔq) in a roughness curve of the inner peripheral surface of the tubular portion is 0.07 or less (excluding 0).

6. The sample tube for a nuclear magnetic resonance apparatus, according to claim 1, wherein an average value of a cut level difference (Rδc) in each of outer peripheral surfaces of the tubular portion and the bottom portion is larger than an average value of a Rδc in an inner peripheral surface of the tubular portion, the Rδc being a difference between a cut level at a load length ratio of 25% in a roughness curve and a cut level at a load length ratio of 75% in the roughness curve.

7. The sample tube for a nuclear magnetic resonance apparatus, according to claim 6, wherein the average value of the cut level difference (Rδc) in the outer peripheral surface of the tubular portion is 0.4 µm or less (excluding 0 µm), the Rδc being the difference between the cut level at a load length ratio of 25% in the roughness curve and the cut level at a load length ratio of 75% in the roughness curve.

8. The sample tube for a nuclear magnetic resonance apparatus, according to claim 1, 6, or 7, wherein the inner peripheral surface of the tubular portion has a smaller average value of a root mean square slope (RΔq) in a roughness curve than each of outer peripheral surfaces of the tubular portion and the bottom portion.

9. The sample tube for a nuclear magnetic resonance apparatus, according to claim 8, wherein the average value of the root mean square slope (RΔq) in a roughness curve of the outer peripheral surface of the tubular portion is 0.07 or less (excluding 0).

10. The sample tube for a nuclear magnetic resonance apparatus, according to any one of claims 1 to 9, wherein
at least one selected from the group consisting of the second opposing surface, an outer peripheral surface of the tubular portion, an inner peripheral surface of the tubular portion, and an outer peripheral surface of the bottom portion is a polished surface, and the polished surface is subjected to etching treatment.

11. A bearing unit comprising:
the sample tube for a nuclear magnetic resonance apparatus, according to any one of claims 1 to 10; and
a bearing made of a ceramic containing zirconium oxide or aluminum oxide as a main component, the bearing supporting both ends in an axial direction of the sample tube for a nuclear magnetic resonance apparatus.

12. A nuclear magnetic resonance apparatus comprising the bearing unit according to claim 11.

13. A manufacturing method of the sample tube for a nuclear magnetic resonance apparatus according to any one of claims 1 to 10, the method comprising:
adhering water to the first opposing surface of the tubular portion and/or the second opposing surface of the bottom portion to adsorb the tubular portion and the bottom portion to each other, and then pressing the tubular portion and the bottom portion along the axial direction and performing heat treatment.

14. The manufacturing method according to claim 13, wherein an inner periphery of the tubular portion is polished to form an inner peripheral surface before the heat treatment.

15. The manufacturing method according to claim 13 or 14, wherein after the heat treatment, an outer periphery of the tubular portion and/or an outer periphery of the bottom portion is ground or polished to form an outer peripheral surface.
